# EUROPEAN PATENT SPECIFICATION

(11) **EP 2 824 676 B1**
(45) Date of publication and mention of the grant of the patent: **10.05.2017**
(21) Application number: 13757358.0
(22) Date of filing: 08.03.2013
(51) Int. Cl.: H01B 13/00, H05K 3/10

(54) **METHOD FOR MANUFACTURING TRANSPARENT CONDUCTIVE PATTERN**
VERFAHREN ZUR HERSTELLUNG EINES TRANSPARENTEN LEITFÄHIGEN MUSTERS
PROCÉDÉ DE FABRICATION D'UN MOTIF CONDUCTEUR TRANSPARENT

(30) Priority: 09.03.2012 JP 2012053492
(43) Date of publication of application: 14.01.2015
(73) Proprietor: Showa Denko K.K., Tokyo 105-8518 (JP); Osaka University, Suita-shi, Osaka 565-0871 (JP)
(72) Inventor: SUGANUMA, Katsuaki, Suita-shi Osaka 565-0871 (JP); NOGI, Masaya, Suita-shi Osaka 565-0871 (JP); JIU, Jinting, Suita-shi Osaka 565-0871 (JP); SUGAHARA, Tohru, Suita-shi Osaka 565-0871 (JP); UCHIDA, Hiroshi, Tokyo 105-8518 (JP); SHINOZAKI, Kenji, Tokyo 105-8518 (JP)
(74) Representative: Strehl Schübel-Hopf & Partner
(86) International application number: PCT/JP2013/056497
(87) International publication number: WO 2013/133420

(56) References cited:
- JP-A- 2009 094 033
- JP-A- 2009 129 607
- JP-A- 2009 146 576
- JP-A- 2012 009 506
- JP-B2- 4 882 027
- US-A1- 2008 286 488
- US-A1- 2009 233 086
- Eric C. Garnett: "Self-limited plasmonic welding of silver nanowire junctions", Nature Materials, vol. 11 5 February 2012 (2012-02-05), pages 241-249, XP002748197, ISSN: 1476-1122, DOI: 10.1038/NMAT3238 Retrieved from the Internet: URL:http://www.nature.com/nmat/journal/v11 /n3/full/nmat3238.html [retrieved on 2015-10-23]

## Description

### Technical Field

The present invention relates to a method for forming a transparent conductive pattern.

### Background Art

Conventionally, a vacuum-deposited metal oxide, such as an indium-tin oxide (ITO), has been used to form a transparent conductive film on a dielectric surface such as a glass substrate.

However, there are following drawbacks. The vacuum-deposited metal oxide such as ITO is fragile and has little bending resistance. Further, a vacuum process is necessary for producing thin films, resulting in the increase of the production costs. In addition, at the time of producing thin films, the temperature must be high, and thus, resin substrates such as plastic films having a low heat resistance cannot be used. In order to process the thin film into a predetermined pattern, an etching process is required, resulting in the decrease of productivity.

Therefore, as a transparent conductive pattern forming method which does not require a vacuum process or a process under a high temperature atmosphere, various transparent conductive pattern forming methods using metal nanowires have been proposed. For example, Patent Document 1 discloses a method for forming a transparent conductor by dispersing metal nanowires in a liquid, and drying the liquid to form a metal nanowire mesh layer on a substrate. Further, Patent Document 1 also discloses that the conductivity can be increased by applying pressure or heat to the metal nanowire mesh layer.

Patent Document 2 discloses a conductive film in which linear metal nanowires are joined to each other at intersections to form a mesh, and also discloses that the joining is performed by pressure bonding or plating.

Non-patent Document 1 discloses a technology to form a network by irradiating 30 w/cm² of light to silver nanowires for 10 to 120 seconds.

### Citation List

### Patent Document

Patent Document 1: JP 2009-505358 T
Patent Document 2: WO 2009/035059

### Non-Patent Document

Non-Patent Document 1: Self-limited plasmonic welding of silver nanowire junctions NATURE MATERIALS (2012) DOI: 10.1038/NMAT3238 Eric C. Garnett, Wenshan Cai, et al. Summary

The conductivity of the metal nanowire mesh can be increased, by applying pressure or heat in Patent Document 1, and by applying plating in Patent Document 2. However, there is still a trade-off relationship between transparency and conductivity. Increasing both transparency and conductivity cannot be sufficiently performed. Further, in Patent Document 1, a drying furnace is used to apply heat, but the application of the drying furnace to a resin substrate is difficult. In Non-Patent Document 1, high-energy light is irradiated for a long time to thereby heat the silver nanowires to a high temperature, and thus, using this disclosure to a resin substrate is difficult.

The object of the present invention is to provide a transparent conductive pattern producing method capable of applying to a resin substrate having a lower heat resistance, and capable of increasing the conductivity.

In order to attain the above object, an embodiment of the present invention is a method for producing a transparent conductive pattern as disclosed in the claims.

### Effect of Invention

According to the present invention, a transparent conductive pattern can have an increased conductivity by pulsed light irradiation.

### Brief Description of Drawings

FIG. 1 is a diagram illustrating the definition of pulsed light.
FIG. 2 is a diagram showing SEM images of silver nanowires produced according to an example of the present invention.

### Description of Embodiments

Hereinbelow, an exemplary embodiment of the present invention (hereinafter, referred to as an embodiment) will be described.

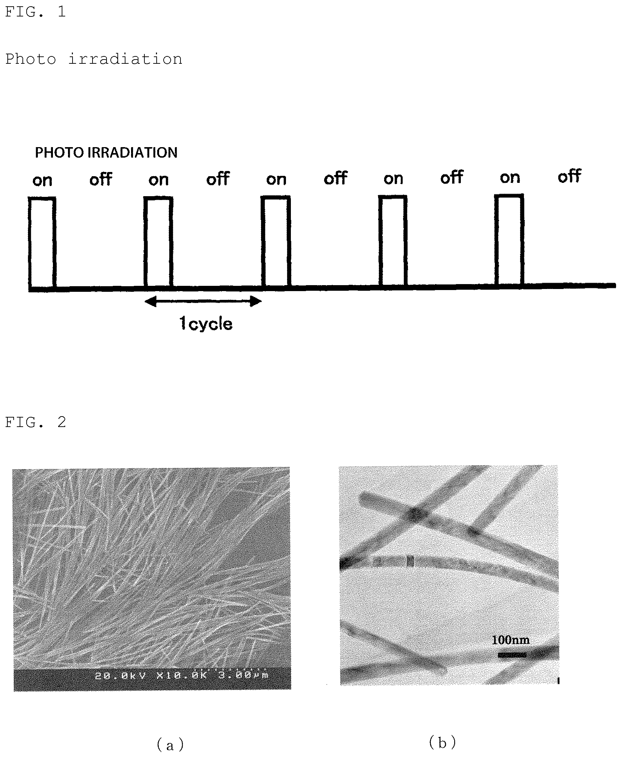

A transparent conductive pattern according to the present embodiment is configured to include metal nanowires, and the transparent conductive pattern is formed by irradiating pulsed light to the metal nanowires deposited on a substrate to join intersections of the metal nanowires. In the present specification, the "pulsed light" is a light having a short photo irradiation period (irradiation time). When a plurality of times of photo irradiation are repeated, as shown in FIG. 1, there is a period in which photo irradiation is not performed (irradiation interval (off)) between a first photo irradiation period (on) and a second photo irradiation period (on). In FIG. 1, the pulsed light is illustrated to have a constant light intensity, but the light intensity may vary within one photo irradiation period (on). The pulsed light is irradiated from a light source provided with a flash lamp such as a xenon flash lamp. Using such a light source, pulsed light is irradiated to metal nanowires deposited on the substrate. When irradiation is repeated for n-times, one cycle (on + off) in FIG. 1 is repeated for n-times. At the time of repeated irradiation, it is preferable to cool the substrate side so that the substrate can be cooled to a temperature near the room temperature when the next pulsed light irradiation is performed.

One irradiation period (on) of the pulsed light is preferably from 20 microseconds to 50 milliseconds, although the period may vary depending on the light intensity. If the period is less than 20 microseconds, sintering does not progress, resulting in providing a lower effect of increasing the performance of a conductive pattern. If the period is longer than 50 milliseconds, there may be bad influences on the substrate due to photodegradation and thermal degradation, and further, nanowires may be easily blown away. More preferably, the irradiation period is from 50 microseconds to 10 milliseconds. Due to the reasons mentioned above, pulsed light instead of continuous light is used in the present embodiment. A single shot of the pulsed light is effective, but the irradiation may be repeated as mentioned above. When the irradiation is repeated, the irradiation interval (off) is preferably in a range from 20 microseconds to 5 seconds, and more preferably in a range from 2000 microseconds to 2 seconds. If the irradiation interval is shorter than 20 microseconds, the pulsed light becomes similar to a continuous light and another irradiation is performed after one irradiation without leaving enough time for cooling. Thus, the substrate is heated to a very high temperature. The irradiation interval longer than 5 seconds is not preferable because the processing time becomes long.

Here, the metal nanowire is a rod-shaped or string-shaped particle which is made of metal and which has a nanometer size. Namely, the metal nanowire means a metal having a diameter in the order of nanometer. In the present specification, the nanowire may include a metal nanotube having a shape of porous or nonporous tube (the center is hollow). In the present embodiment, the metal nanowire cannot be a branched shape, or a shape as if spherical particles are beaded.

The material for the metal nanowire is not limited, and may be, for example, iron, cobalt, nickel, copper, zinc, ruthenium, rhodium, palladium, silver, cadmium, osmium, iridium, platinum, or gold. In view of the high conductivity, copper, silver, platinum, and gold are preferable, and silver is more preferable. The metal nanowire (silver nanowire) preferably has a diameter of 10 to 300 nm and a length of 3 to 500 µm, and more preferably has a diameter of 30 nm to 100 nm and a length of 10 to 100 µm. If the diameter is too small, strength is not enough when the nanowires are joined, whereas if the diameter is too large, the transparency may be decreased. If the length is too short, intersections cannot be effectively overlapped, whereas if the length is too long, the printing property may be decreased.

The metal nanowire may be synthesized by a known method. For example, a method for reducing silver nitrate in a solution may be used. A specific method for reducing silver nitrate in a solution may be a method for reducing a nanofiber made of metal-complex peptide lipid, a method for reducing silver nitrate by heating in ethylene glycol, a method for reducing silver nitrate in a solution of sodium citrate, and the like. Among these methods, the method for reducing silver nitrate by heating in ethylene glycol is preferable because the metal nanowire can be produced most easily.

Upon producing a transparent conductive pattern according to the present embodiment, metal nanowires are deposited on an appropriate substrate to have a predetermined pattern shape (including a solid pattern), and pulsed light having a pulse width in the range of 20 microseconds to 50 milliseconds, and more preferably, in the range of 50 microseconds to 10 milliseconds is irradiated to the metal nanowires using a pulsed xenon irradiation lamp to thereby join the intersections of the metal nanowires. Here, joining means that the material (metal) of the nanowires absorbs the irradiated pulsed light, internal heat generation occurs more effectively at the intersecting portions, and thus, the intersecting portions are welded. By this joining, the contact area between nanowires at the intersecting portion increases, leading to the decrease of surface resistance. Accordingly, intersections of the metal nanowires are joined by irradiating the pulsed light, and thereby, a conductive pattern having metal nanowires in a mesh shape can be formed. Therefore, the conductivity of the transparent conductive pattern can be increased. With respect to the mesh formed by the metal nanowires, a closely-spaced mesh is not preferable, because if the space is not enough, the light transmission rate may be decreased.

The method to deposit metal nanowires on a substrate is not limited, but the method may be, for example, wet coating. The wet coating means a process to form a film by coating a liquid (metal nanowire dispersion liquid) on the substrate. The wet coating to be used in the present embodiment is not limited and can be any known methods, and thus, spray coating, bar coating, roll coating, die coating, inkjet coating, screen coating, dip coating, drop coating, relief printing, intaglio printing, gravure printing, and the like, can used. Further, subsequent to the wet coating, a process to remove the used solvent by heating the substrate, a process to wash away additives such as a dispersant, and the like, may be included. Further, the wet coating may be performed not only once, but also repeatedly for a plurality of times. Also, the pattern printing can be performed by gravure printing or screen printing.

The dispersion medium to be used for the wet coating may be, for example, a ketone compound such as acetone, methyl ethyl ketone, cyclohexanone; an ester compound such as methyl acetate, ethyl acetate, butyl acetate, ethyl lactate, methoxyethyl acetate,; an ether compound such as diethyl ether, ethylene glycol dimethyl ether, ethyl cellosolve, butyl cellosolve, phenyl cellosolve, dioxane; an aromatic compound (hydrocarbon) such as toluene, xylene; an aliphatic compound (hydrocarbon) such as pentane, hexane; a halogenated hydrocarbon such as methylene chloride, chlorobenzene, chloroform; an alcohol compound such as methanol, ethanol, n-propanol, isopropanol, 1-methoxy-2-propanol (PGME), ethylene glycol, diethylene glycol, triethylene glycol, dipropylene glycol, terpineol, glycerin, diglycerin, bornyl cyclohexanol, bornyl phenol, isobornyl cyclohexanol, isobornyl phenol; water; and a mixing solvent of any of above. Among the aforementioned dispersion medium, a water-soluble solvent is preferable, and particularly, alcohol and water are preferable.

In order that the nanowire has a preferable dispersion property, and the obtained coated film has a preferable pattern formation property, high conductivity, and a preferable optical property, the content of the nanowire in the nanowire dispersion liquid is preferably 0.01 to 10% by mass, and more preferably, 0.05 to 2% by mass, relative to the total mass of the dispersion liquid. When the metal nanowire content is less than 0.01% by mass, it is difficult to obtain a desired conductivity. The deposition (coating) process must be repeated for a plurality of times. When the content exceeds 10% by mass, extremely thin deposition (coating) must be performed in order to obtain a desired transparency, and thus, workability is not good.

In addition, the metal nanowire dispersion liquid may contain other component such as a binder resin, a corrosion inhibitor, an adhesive accelerator, a surfactant, etc., in accordance with needs, as far as the property of the dispersion liquid is not damaged. By coating a dispersion liquid containing a binder resin, adhesiveness between the metal nanowire and the substrate increases at the time of photo irradiation. A polymer compound which can be used as a binder resin may be a thermoplastic resin or a thermoset resin, which is, for example, a poly-N-vinyl compound such as polyvinylpyrrolidone, polyvinyl caprolactone, a polyalkylene glycol compound such as polyethyleneglycol, polypropyleneglycol, poly THF, polyurethane, a cellulose compound and a derivative thereof, an epoxy compound, a polyester compound, chlorinated polyolefin, and a polyacrylic compound. If the binder resin is contained too much, the binder resin may be present between the metal nanowires, resulting in the decrease in conductivity. Therefore, the content of the binder resin is preferably 50 parts by mass or lower, more preferably 30 parts by mass or lower, and further more preferably 10 parts by mass, relative to 100 parts by mass of the metal nanowire, and is preferably 2% by mass or lower, more preferably 1.2% by mass or lower, and further more preferably 0.4% by mass or lower, relative to the total mass of the dispersion liquid. The lower limit is not specifically determined, but usually, the lower limit is 0.01 parts by mass, preferably 0.1 parts by mass, and more preferably 0.5 parts by mass, relative to 100 parts by mass of the metal nanowire.

The corrosion inhibitor may be benzotriazole, etc. The adhesive accelerator may be 2-hydroxy methyl cellulose, etc. The surfactant may be a product having a trade name F-472SF (manufactured by DIC Corporation), etc.

The material for the substrate is not limited, but may be ceramics such as glass, alumina, etc., metal such as iron, aluminum, copper, etc., a thermoplastic resin, a photocurable resin, and a thermoset resin, such as a polyester resin, a cellulose resin, a vinyl alcohol resin, a vinyl chloride resin, a cyclo-olefin resin, a polycarbonate resin, an acrylic resin, an ABS resin, etc., and the like.

### Examples

Hereinafter, specific examples of the present invention will be explained. The examples are described below for the purpose of easy understanding of the present invention, and the present invention is not limited to these examples.

### (Production of Silver Nanowire)

Polyvinylpyrrolidone K-90 (manufactured by Nippon Shokubai Co., Ltd.) (0.049 g), AgNO₃ (0.052 g), and FeCl₃ (0.04 mg) were dissolved in ethylene glycol (12.5 ml), and were heated and reacted at 150°C for one hour. The resulting precipitate was isolated by centrifugal separation, the precipitate (silver nanowire) was dispersed again in ethanol, and a dispersion liquid containing 2% by mass of silver nanowire was obtained. FIG. 2 (a) and (b) show SEM images of the silver nanowire obtained by removing ethanol from the dispersion liquid, and drying. The SEM used was FE-SEM S-5200 manufactured by Hitachi High-Technologies Corporation.

As can be seen from FIG. 2(a) and (b), the silver nanowire had a rod shape, and the diameter of the rod was about 70 nm, the length thereof was about 10 to 20 µm. 95% or more of the precipitates were nanowires grown into the rod shape, and the remaining precipitates were grain-shaped.

The silver nanowire, which was obtained by isolation by centrifugal separation and subsequent drying, was subjected to thermogravimetric analysis under atmosphere within the temperature range of 50 to 600°C at the temperature rise rate of 20°C/min, resulting in 5.8% of decrease in weight. This suggests that polyvinylpyrrolidone K-90 used upon preparation was contained in the silver nanowire. For the thermogravimetric analysis, a differential thermal balance TG-DTA galaxy manufactured by Bruker AXS GmbH was used.

The above-mentioned ethylene glycol, polyvinylpyrrolidone K-90, AgNO₃, and FeCl₃ were manufactured by Wako Pure Chemical Industries, Ltd.

The length and the diameter of the silver nano-particle were measured by SEM and TEM. The TEM used was TEM manufactured by JEOL Limited, that is, JEOL, JEM-2100 transmission electron microscope.

### Examples 1 to 12

### (Production of Transparent Conductive Pattern)

The silver nanowire dispersion liquid was diluted by ethanol and prepared to have silver nanowire concentrations described in Table 1. The dispersion liquid was coated on a 125 µm thick PET film (Lumirror, easy-adhesion grade, manufactured by Toray Industries, Inc.) by drop coating, and air-dried for 6 hours, to thereby deposit silver nanowires on the substrate.

Next, a single shot of pulsed light was irradiated to the nanowires deposited on the substrate, using a xenon irradiation device Pulse Forge 3300 manufactured by NovaCentrix. The irradiation conditions of the pulsed light (drive voltage of the light source (V), irradiation time (pulse width msec), and exposure value of the silver nanoparticle deposition layer at the time of irradiation (J/cm²) ) are shown for Examples 1 to 12 in Table 1.

SEM observation after the pulsed light irradiation revealed that projections were generated on the surface of the silver nanowires.

### (Measuring Surface Resistance Value and Transmittance of Transparent Conductive Pattern)

With respect to the silver nanoparticle deposition layers before and after the pulsed-light irradiation under the conditions for Examples 1 to 12 in Table 1, surface resistance values were measured using four-point probe surface resistivity/volume resistivity measurement device LORESTA-GP MCP-T610, manufactured by Mitsubishi Chemical Corporation. The measurement was performed using the drop-coated film cut into 2 cm square.

Further, with respect to Examples 1 to 12, the light transmittance within the visible light range (400 to 800 nm) was measured as a scale for transparency, using a ultraviolet-visible-near infrared spectrophotometer Jasco V-570, manufactured by JASCO Corporation. The results of the measurement are shown in Table 1.

**[Table 1]**

| Examples | Ag Nanowire Concentration | Irradiation Conditions | | | Surface Resistance Value | | | Light Transmittance | |
|---|---|---|---|---|---|---|---|---|---|
| | | Voltage | Time | Exposure Value | Before Irradiation | After Irradiation | Decreasing Rate | Before Irradiation | After Irradiation |
| | % by mass | V | µsec | J/cm² | Ω/□ | | % | % | |
| 1 | 1 | 400 | 200 | 2,08 | 3,00E+02 | 2,00E+02 | 67 | 84 | 83 |
| 2 | 1 | 420 | 200 | 2,38 | 1,50E+02 | 1,00E+02 | 67 | 82 | 81 |
| 3 | 1 | 450 | 200 | 2, 84 | 4,30E+02 | 1,20E+02 | 28 | 85 | 82 |
| 4 | 1 | 500 | 200 | 3,75 | 6,40E+02 | 7,00E+01 | 11 | 88 | 82 |
| 5 | 1 | 520 | 200 | 4,16 | 1,80E+02 | 4,00E+01 | 22 | 83 | 79 |
| 6 | 1 | 540 | 200 | 4,59 | 1,50E+02 | 4,90E+01 | 33 | 82 | 80 |
| 7 | 0,33 | 350 | 30 | 2,23 | 3,50E+04 | 2,00E+03 | 6 | 89 | 89 |
| 8 | 0,25 | 600 | 50 | 1,14 | 5,00E+06 | 1,60E+04 | 0,3 | 90 | 89 |
| 9 | 0,5 | 250 | 1000 | 2,7 | 8,00E+03 | 1,30E+03 | 16 | 88 | 88 |
| 10 | 0,33 | 600 | 300 | 2,23 | 3,40E+04 | 7,10E+03 | 21 | 89 | 79 |
| 11 | 0,33 | 300 | 500 | 0,21 | 6,80E+04 | 8,60E+03 | 13 | 89 | 89 |
| 12 | 0,125 | 300 | 80 | 3,35 | 3,60E+07 | 6,60E+04 | 0,2 | 91 | 90 |
| Comparative Example 1 | 1 | 100°C, 10 minutes | | | 6,40E+02 | 6,24E+02 | 98 | 88 | 88 |

### Comparative Example 1

Using dispersion liquid in which the silver nanowires were dispersed in ethanol to have a concentration of 1% by mass, the silver nanowires were deposited on the substrate in the same way as Examples. Thereafter, instead of the pulsed-light irradiation, heating using a heating furnace (air atmosphere) was performed at 100°C for 10 minutes. The surface resistance values had almost no difference between before and after the heating. Since a PET film was used for the substrate, heating could not be performed at the temperature higher than 100°C.

As shown in Table 1, all of the decreasing ratios of the surface resistance values of the transparent conductive patterns (silver nanowire deposition layers) between before and after the pulsed light irradiation (surface resistance value after irradiation/surface resistance value before irradiation (%)) in Examples 1 to 12 are largely lowered compared to 98% which is the decreasing ratio of the surface resistance value of the transparent conductive pattern between before and after the heating at 100°C (surface resistance value after heating/surface resistance value before heating (%)) in Comparative Example 1. This reflects that joining occurs at the intersecting points of the nanowires by photo irradiation, and the conductivity is increased. Further, welding of nanowires occurs at the intersecting points (joining points) of the nanowires by photo irradiation, leading to the increase of projected area in the vertical direction. Therefore, in Examples 1 to 6 using a dispersion liquid in which the silver nanowires are dispersed in ethanol to have a concentration of 1% by mass, the light transmittance after the photo irradiation is slightly lower than the light transmittance before the photo irradiation. With respect to Examples 1 to 12, even if the silver nanowire concentrations are the same, surface resistance values of the transparent conductive patterns before the pulsed light irradiation are different. This reflects the variability of silver nanowire concentrations in the used silver nanowire dispersion liquids. Further, the light transmittances are approximately 80% or more, which are sufficiently practical.

### Example 13

### (Production of Transparent Conductive Pattern)

A small amount of terpineol (manufactured by Nippon Terpene Chemicals Inc.) was added to the 2% by mass silver nanowire dispersion liquid, and dispersed well. Thereafter, ethanol was distilled away, and solvent displacement was performed. Then, Tersorb MTPH (isobornyl cyclohexanol, manufactured by Nippon Terpene Chemicals, Inc.) and terpineol were added so that final concentration of the dispersion medium became terpineol/Tersorb MTPH=1/8 (mass ratio), and were dispersed well using ARV-310 manufactured by Thinky Corporation to thereby obtain dispersion liquid. The small amount of terpineol which was added first was predetermined by calculation so that the concentration of the finally obtained dispersion liquid became 1% by mass.

Using the above-mentioned dispersion liquid, a 2.5 cm square solid pattern was printed by a screen printer MT-320 TVZ (manufactured by Microtek Inc.). For the substrate, a 125 µm thick PET film (Lumirror, easy-adhesion grade, manufactured by Toray Industries, Inc.) was used. After the printing, drying operations were performed step-by-step, using a hot-air drier, under the conditions shown in Table 2, and thereby, a tack-free printed pattern was obtained.

Next, pulsed light was irradiated to the pattern subjected to the drying. Similar to Examples 1 to 12, a single shot pulsed light irradiation was performed at 600V for 50 µsec, using Pulse Forge3300 manufactured by NovaCentrix. The surface resistance value was measured, and the resistance value was 7.86 Ω/□.

### (Measurement of Surface Resistance Value, Light Transmittance, and Haze of Transparent Conductive Pattern)

Similar to Examples 1 to 12, surface resistance value and light transmittance of the silver nanoparticle printed pattern were measured before and after the pulsed light irradiation, using the four-point probe surface resistivity/volume resistivity measurement device LORESTA-GP MCP-T610, manufactured by Mitsubishi Chemical Corporation. Before the pulsed light irradiation, the resistance value was not low enough to be measured (in Table 2, show as OL). The resistance value was not measurable although the silver nanowire was contained 1% by mass as in Examples 1 to 6. The reason therefor is assumed that the high boiling point solvent used for preparing the dispersion liquid was remained in the coated film even after the drying process. On the other hand, the resistance value after the pulsed light irradiation was 7.86 Ω/□.

Further, for the measurement of light transmittance shown in Table 2, a turbidimeter NDH2000 manufactured by Nippon Denshoku Industries, Co., Ltd. was used.

**[Table 2]**

| Examples | Ag Nanowire Material | Ag Nanowire Concentration | PVP Addition Amount | Drying Conditions | Irradiation Conditions | | | Surface Resistance | | Light Transmittance | |
|---|---|---|---|---|---|---|---|---|---|---|---|
| | | | | | Voltage | Time | Exposure Value | Before Irradiation | After Irradiation | Before Irradiation | After Irradiation |
| | | % by mass | % by mass | | V | µsec | J/cm² | Ω/□ | Ω/□ | % | |
| 13 | Synthesized | 1 | None | 60, 80, 100°C 30 minutes each | 600 | 50 | 1,14 | OL | 7,86 | 80 | 81 |
| 14 | Synthesized | 1 | 0,01 | 60, 80, 100°C 30 minutes each | 600 | 50 | 1,14 | OL | 12,7 | 82 | 82 |
| 15 | Synthesized | 1 | 0,1 | 60, 80, 100°C 30 minutes each | 600 | 50 | 1,14 | OL | 12,6 | 80 | 80 |
| 16 | Synthesized | 1 | 0,5 | 60, 80, 100°C 30 minutes each | 600 | 50 | 1,14 | OL | 16,1 | 81 | 81 |
| 17 | bluenano SLV-NW-35 | 1 | None | 60, 80, 100°C 30 minutes each | 600 | 50 | 1,14 | OL | 5,4 | 77 | 78 |
| 18 | bluenano SLV-NW-35 | 0,5 | None | 60, 80, 100°C 30 minutes each | 600 | 50 | 1,14 | OL | 21,8 | 85 | 85 |
| 19 | bluenano SLV-NW-35 | 0,33 | None | 60, 80, 100°C 30 minutes each | 600 | 50 | 1,14 | OL | 129,9 | 87 | 87 |
| 20 | bluenano SLV-NW-35 | 0,25 | None | 60, 80, 100°C 30 minutes each | 600 | 50 | 1,14 | OL | 587,8 | 89 | 88 |

### Examples 14 to 16

A transparent conductive pattern was produced in the same way as Example 13, except that a dispersion liquid prepared by adding polyvinylpyrrolidone K-90 (manufactured by Nippon Shokubai Co., Ltd.) to the dispersion liquid used in Example 13 to have the concentration shown in Table 2, was used. The surface resistance value and the light transmittance were measured. The results are shown in Table 2. It was confirmed that even if a binder resin was added in the dispersion liquid, conductivity can be obtained by pulsed light irradiation.

### Examples 17 to 20

A transparent conductive pattern was produced in the same way as Example 13, except that a dispersion liquid prepared by adding a marketed product of silver nanowire, instead of the above-mentioned synthesized silver nanowire, to have the concentration shown in Table 2, the marketed product being SLV-NW-35 (dispersed in isopropanol, silver nanowire having diameter of 35 nm and length of approximately 15 µm (catalog values), manufactured by Blue Nano, Inc.), was used. The surface resistance value and the light transmittance were measured. The results are shown in Table 2. In Examples 13 and 17, the silver nanowire concentrations are the same (1% by mass) and no binder resins were added. In these Examples, the surface resistance values and the light transmittances were in the same level. There found a tendency that as the silver nanowire concentration is decreased, the surface resistance value gradually increases and the light transmittance gradually increases.

## Claims

1. A method for producing a transparent conductive pattern, wherein pulsed light from a xenon irradiation lamp having a pulse width of 20 microseconds to 50 milliseconds is irradiated to metal nanowires deposited on a substrate to join intersections of the metal nanowires.

2. A method for producing a transparent conductive pattern according to claim 1, wherein the pulsed light is irradiated for a plurality of times.

3. A method for producing a transparent conductive pattern according to claim 1 or claim 2, wherein the metal nanowires are silver nanowires.

4. A method for producing a transparent conductive pattern according to claim 3, wherein the silver nanowire has a diameter of 10 to 300 nm and a length of 3 to 500 µm.

5. A method for producing a transparent conductive pattern according to claim 3 or claim 4, wherein the silver nanowire has a diameter of 100 nm or less and a length of 10 µm or more.

6. A method for producing a transparent conductive pattern according to any one of claims 1 to 5, wherein deposition of the metal nanowires onto the substrate is performed by coating a dispersion liquid having the metal nanowires dispersed therein on the substrate, and drying.

7. A method for producing a transparent conductive pattern according to claim 6, wherein the dispersion liquid contains a binder resin.

8. A method for producing a transparent conductive pattern according to claim 7, wherein the binder resin is a poly-N-vinyl compound.

9. A method for producing a transparent conductive pattern according to claim 8, wherein the poly-N-vinyl compound is poly-N- vinylpyrrolidone or poly-N-vinylcaprolactam.

10. A method for producing a transparent conductive pattern according to any one of claims 1 to 9, wherein the material for the substrate is a polyester resin, a cellulose resin, a vinyl alcohol resin, a vinyl chloride resin, a cyclo-olefin resin, a polycarbonate resin, an acrylic resin, or a ABS resin.

## Patentansprüche

1. Verfahren zum Herstellen eines transparenten leitenden Musters, wobei Pulslicht von einer Xenonbestrahlungslampe mit einer Pulsbreite von 20 Mikrosekunden bis 50 Millisekunden auf Metallnanodrähte, die auf einem Substrat abgeschieden sind, gestrahlt wird, wobei die Zwischenräume der Metallnanodrähte verbunden werden.

2. Verfahren zum Herstellen eines transparenten leitenden Musters nach Anspruch 1, wobei das Pulslicht viele Male gestrahlt wird.

3. Verfahren zum Herstellen eines transparenten leitenden Musters nach Anspruch 1 oder 2, wobei die Metallnanodrähte Silbernanodrähte sind.

4. Verfahren zum Herstellen eines transparenten leitenden Musters nach Anspruch 3, wobei der Silbernanodraht einen Durchmesser von 10 bis 300 nm und eine Länge von 3 bis 500 µm aufweist.

5. Verfahren zum Herstellen eines transparenten leitenden Musters nach Anspruch 3 oder 4, wobei der Silbernanodraht einen Durchmesser von 10 nm oder weniger und eine Länge von 10 µm oder mehr aufweist.

6. Verfahren zum Herstellen eines transparenten leitenden Musters nach einem der Ansprüche 1 bis 5, wobei die Abscheidung der Metallnanodrähte auf das Substrat durchgeführt wird, indem eine Dispersionsflüssigkeit mit darin dispergierten Metallnanodrähten auf das Substrat abgeschieden und getrocknet wird.

7. Verfahren zum Herstellen eines transparenten leitenden Musters nach Anspruch 6, wobei die Dispersionsflüssigkeit ein Bindemittelharz enthält.

8. Verfahren zum Herstellen eines transparenten leitenden Musters nach Anspruch 7, wobei das Bindemittelharz eine Poly-N-vinylverbindung ist.

9. Verfahren zum Herstellen eines transparenten leitenden Musters nach Anspruch 8, wobei die Poly-N-vinylverbindung Poly-N-vinylpyrrolidon oder Poly-N-vinylcaprolactam ist.

10. Verfahren zum Herstellen eines transparenten leitenden Musters nach einem der Ansprüche 1 bis 9, wobei das Material für das Substrat ein Polyesterharz, ein Zelluloseharz, ein Vinylalkoholharz, ein Vinylchloridharz, ein Cycloolefinharz, ein Polycarbonatharz, ein Acrylharz oder ein ABS-Harz ist.

## Revendications

1. Procédé de fabrication d'un motif conducteur transparent, dans lequel une lumière pulsée en provenance d'une lampe irradiante au xénon présentant une largeur d'impulsions de 20 microsecondes à 50 millisecondes est irradiée sur des nanofils métalliques déposés sur un substrat de manière à réaliser la liaison des nanofils métalliques au niveau de leurs intersections.

2. Procédé de fabrication d'un motif conducteur transparent selon la revendication 1, dans lequel la lumière pulsée est irradiée plusieurs fois.

3. Procédé de fabrication d'un motif conducteur transparent selon la revendication 1 ou la revendication 2, dans lequel les nanofils métalliques sont des nanofils d'argent.

4. Procédé de fabrication d'un motif conducteur transparent selon la revendication 3, dans lequel le nanofil d'argent présente un diamètre compris entre 10 nm et 300 nm et une longueur comprise entre 3 µm et 500 µm.

5. Procédé de fabrication d'un motif conducteur transparent selon la revendication 3 ou la revendication 4, dans lequel le nanofil d'argent présente un diamètre de 100 nm, ou moins, et une longueur de 10 µm, ou plus.

6. Procédé de fabrication d'un motif conducteur transparent selon l'une quelconque des revendications 1 à 5, dans lequel le dépôt des nanofils métalliques sur le substrat est réalisé par application sur un substrat, puis séchage, d'une dispersion liquide incorporant les nanofils métalliques dispersés dans celle-ci.

7. Procédé de fabrication d'un motif conducteur transparent selon la revendication 6, dans lequel la dispersion liquide contient une résine liante.

8. Procédé de fabrication d'un motif conducteur transparent selon la revendication 7, dans lequel la résine liante est un composé de poly-N-vinyle.

9. Procédé de fabrication d'un motif conducteur transparent selon la revendication 8, dans lequel le composé de poly-N-vinyle est du poly-N-vinylpyrrolidone ou du poly-N-vinylcaprolactame.

10. Procédé de fabrication d'un motif conducteur transparent selon l'une quelconque des revendications 1 à 9, dans lequel le matériau pour le substrat est une résine polyester, une résine cellulosique, une résine d'alcool vinylique, une résine de chlorure de vinyle, une résine cyclo-oléfinique, une résine polycarbonate, une résine acrylique ou une résine ABS.
